# EUROPEAN PATENT SPECIFICATION

(11) **EP 1 330 642 B1**
(45) Date of publication and mention of the grant of the patent: **14.11.2007**
(21) Application number: 01980648.8
(22) Date of filing: 29.10.2001
(51) Int. Cl.: G01N 27/30, C23C 14/58, C23C 8/08, C23C 8/36

(54) **METHOD FOR CHLORINE PLASMA MODIFICATION OF SILVER ELECTRODES**
VERFAHREN ZUR MODIFIZIERUNG VON SILBER-ELEKTRODEN MITTELS EINES CHLORPLASMAS
PROCEDE DE MODIFICATION DU PLASMA DE CHLORE DES ELECTRODES D'ARGENT

(30) Priority: 27.10.2000 GB 0026276
(43) Date of publication of application: 30.07.2003
(73) Proprietor: Uutech Limited, Coleraine, Northern Ireland BT52 1SA (GB)
(72) Inventor: MCLAUGHLIN, James, Belfast BT7 2GH (GB); MAGUIRE, Paul, Damian, Belfast BT14 6JR (GB); MCADAMS, Eric, Thomas, Whitehead BT38 9PZ (GB)
(74) Representative: Earnshaw, Geoffrey Mark
(86) International application number: PCT/GB2001/004757
(87) International publication number: WO 2002/035221

(56) References cited:
- EP-A- 0 702 098
- EP-A- 1 026 500
- WO-A-01/32303
- DATABASE INSPEC [Online] INSTITUTE OF ELECTRICAL ENGINEERS, STEVENAGE, GB; REN F ET AL: "Improved n-type GaAs Ohmic contacts compatible with a chlorine-based dry-etch process" Database accession no. 3932382 XP002190150 & JOURNAL OF ELECTRONIC MATERIALS, APRIL 1991, USA, vol. 20, no. 4, pages 305-308, ISSN: 0361-5235
- RAVEH A ET AL: "R.F. PLASMA NITRIDING OF TI-6A1-4V ALLOY" THIN SOLID FILMS, ELSEVIER-SEQUOIA S.A. LAUSANNE, CH, vol. 186, no. 2, 1 May 1990 (1990-05-01), pages 241-256, XP000133418 ISSN: 0040-6090

## Description

This invention relates to the chlorine plasma modification of silver electrodes.

Silver electrodes coated with silver chloride layers (Ag/AgCl electrodes) have for many years formed the basis for medical electrodes due to the excellent charge transfer characteristics and non polarisability of the silver chloride material. The main applications of Ag/AgCl electrodes concern amperometric (current sensitive) and potentiometric (voltage sensitive) sensors. Indeed, Ag/AgCl layers have formed the basis for many electrocardigram (ECG) electrodes and have been incorporated into both sensing devices and reference electrodes.

One common way of producing Ag/AgCl electrodes is the electrochemical technique whereby chloride ions are deposited on the silver surface reacting therewith to form a silver chloride layer (AgCl). Sintered Ag/AgCl electrodes have been used in the past as well as serigraphic inks. The latter is known as "thick film" technology and combines a mixture of silver and silver chloride particles trapped in a polymer. A common alternative to these methods is chemical chloriding, which is a technique applied in both thin and thick film technology.

The thicker the film of silver chloride (AgCl) formed on the silver electrode the less sensitive the electrode becomes. As such, thin film technology is becoming an essential key of sensing and bio-sensing, due to the concept of miniaturisation. Increasingly microscopic scale devices allow for more accurate readings. Therefore, Ag/AgCl electrodes have been designed and adapted to thin-film technology in order to be used as micro-sensors.

However, the present thin film methods of producing Ag/AgCl electrodes in general have been found not to be satisfactory. The technique of chemical chloriding thin films is a delicate task which is difficult to control and often results in the formation of a silver chloride film which is too thick and does not have uniform properties throughout. The thicker the silver chloride layer the higher the electrical impedance of the electrode which reduces the sensitivity. Also, chemical chloriding simply involves the surface absorption of chlorine on the silver electrode and as such does not always provide an AgCl film with a strong adhesion to the surface of the silver electrode.

Depositing chloride ions on the silver electrode using electroplating is also a difficult process to control and the resulting Ag/Cl layer is often be too thick and lacking in uniformity. It has also been shown that this technique does not provide good adhesion of the AgCl layer to the silver electrode and also induces surface cracking, both of which reduce the effectiveness of the electrode.

EP 1026500 discloses a silver/silver halide electrode composed of a non-electroconductive support sheet (11), a silver metal layer (22) and a silver halide layer (33) in order. This is improved in its sensitivity by making the silver halide layer almost free from heavy metal element, for instance, by oxidizing the silver metal layer on its surface side with an oxidizing compound containing no heavy metal element or a chelated ferric oxidizing compound in the presence of a halide containing no heavy metal element.

The present invention is directed to overcoming these problems and provides a method which can more closely control the formation and thickness of the silver chloride layer. The method also provides a silver chloride layer which is more uniform and stable in structure, thereby providing a more sensitive, stable and accurate reading.

According to a first aspect of the present invention there is provided a method to reduce the impedance of a silver electrode surface wherein the surface is treated with a chlorine plasma.

Control of the power, flux density and timing provide the manner to modify the silver surface, and so implant the chlorine atoms and ions into the silver. Different control parameters provide different silver surfaces, e.g. thicker or thinner, as desired or necessary.

Preferably, the silver electrode is in the form of a silver thin-film. More preferably, the silver electrode is fabricated by the evaporation of silver onto a glass plate to form a silver thin-film. The glass plate is preferably cleaned and coated with a thin metallic sub-layer prior to the addition of silver. Preferably, the sub-layer is a chromium or nichrome sub-layer and is coated on the glass plate using a sputtering system.

Typically, the sputtering system can be a Nordiko NM200/RFG1250 sputtering system using an inert plasma and a chromium target. Preferably, the inert plasma is argon plasma.

The modification of the surface of the silver electrode can take place in a plasma chamber. A surface of the silver electrode is bombarded with the chlorine plasma. Preferably, the modification of the silver electrode takes place in a reaction ion etching (RIE) radio-frequency (RF) plasma chamber. Preferably, the chamber is pumped down prior to the modification of the silver electrode.

Preferably, the plasma can be in the form of a stream and is formed from a chlorine gas.

The modification of the silver surface can take place in a plasma chamber. A surface of the silver electrode is bombarded with the plasma stream. Preferably, the modification of the silver takes place in a reaction ion etching (RIE) radio-frequency (RF) plasma chamber. Preferably, the chamber is pumped down prior to the modification of the metal.

The method is suitable, for example, for the treatment of silver electrodes in the form of a thin-film, possibly fabricated by the evaporation of the metal onto a glass plate.

The invention extends to a silver electrode, having a silver chloride surface layer provided by plasma modification.

The invention will be more clearly understood by way of description thereof with reference to the accompanying drawings in which:-
Fig. 1(a) is a graph of the impedance spectrum of silver thin-film before treatment according to the present invention;
Fig. 1(b) is a graph of the impedance spectra of silver thin-film after electrochloriding in a 0.5M KCl solution;
Fig. 1(c) is a graph of the impedance spectra of silver thin-film after treatment according to the present invention;
Fig. 2(a) is a SEM view of the surface of silver thin-film after electrochloriding (x 2.5k);
Fig. 2(b) is a SEM view of the surface of silver thin-film after treatment according to the present invention (x 15k);
Fig. 3 is a graph of EDX measurements realised on silver thin-film showing spectra of Ag (white) and AgCl (red);
Fig. 4 is a graph of XPS spectra of silver thin-film modified according to the present invention;
Fig. 5 are graphs showing Ag 3d5/2 and Ag 3d5/2 binding energy shifts; and
Fig. 6 are graphs showing Cl 2p3/2 and Cl 2p3/2 binding energy shifts.

To aid in the understanding and advantages of the present invention, experimental testing was undertaken on a silver electrode modified according to the present invention (2) and compared to identical testing on a non-coated silver electrode, and on a silver electrode with chloride ions deposited thereon using the technique of electroplating (1).

For the purposes of this experiment, all the silver electrodes used were fabricated by evaporating silver in a form 99.99% pure(for example, 99.99% purity, Goodfellow, Cambridge U.K. type silver)to form a silver thin-film on top of a BDH plain microscope glass slide. Evaporation was carried out using an electron-beam chamber (Leybold L560E⁻Beam), at an evaporation rate of 100Å/s⁹, under high vacuum (2.10⁻⁵ mbar). Prior to the evaporation stage, the glass sides were cleaned and then introduced into a Nordiko NM200/RFG1250 sputtering system, using an argon plasma and a chromium target. A sub-layer of chromium was deposited on the glass slide and this improved the adhesion of the silver thin-film to the glass slide when deposited thereon. The silver electrodes thus formed (electrode samples) were then further treated as follows:-

### (1) ELECTROCHEMICAL CHLORIDING - ELECTROPLATING

A portion of the electrode samples were encapsulated in an electrochemical cell, allowing an active electrode surface of 0.96 cm². The electrodes were dipped into a 0.5M potassium chloride (KCl) solution. An anodic current of 0.98 mAmps was applied for several time durations (5s, 7s, 10s, 15s, 20s and 25s). The chloride ions in the KCl solution migrated to the positive silver electrode and were deposited thereon. The chloride ions reacted with the silver and formed a layer of silver chloride (AgCl). The electrochemical chloriding was performed using AutoLab^{™} instrumentation, for example a General Purpose Electrochemical System (GPES) and Frequency Response Analyser (FRA).

### (2) PLASMA MODIFICATION

Another portion of the electrode samples were modified according to the present invention with a chlorine plasma stream. The plasma stream used was a pure chlorine plasma stream, in a Reaction Ion Etching (RIE) radio-frequency (RF) plasma chamber. Typical operating parameters for the plasma chamber are given below in Table 1.

**Table 1**

| |
|---|
| 1 to 100 mTorr: |
| 5 to 500 Watts (per cm²) : |
| 1 to 50 sccms (standard cm³) of chlorine: |
| 1ms to 5 seconds plasma time |

Operating Parameters for preparing, for example, a low impedance electrode for a suitable system, are:
10-20 mTorr
∼170 Watts 5-10 sccms
1 second plasma time

### EXPERIMENTAL TESTING

The above treated electrode samples (electrochemical electrode and plasma electrode) and the standard non-treated electrodes were then subjected to the following tests:-
Electrochemical tests;
X-Ray Photoelectron Spectroscopy (XPS) investigations;
Energy Dispersive X-Ray Spectroscopy (EDX) analysis; and
Scanning Electron Microscopy (SEM) analysis.

All the electrochemical tests and measurements were carried out with an AutoLab apparatus (GPES and FRA). A 5mV AC voltage was applied using a range of frequency from 10,000Hz to 0.1Hz for all these tests and measurements were carried out in a phosphate buffer solution (PBS), to which 0.9% NaCl was added.

XPS investigations were carried out on a KRATOS XSAM 800 apparatus. The X-ray source was run with MgKα X-rays at 240W (13.8 kV, 18mA).

SEM pictures were taken from a SEM/EDX system, an Hitachi S3200N microscope interfaced with an Oxford Instrument Link ISIS EDX spectrometer.

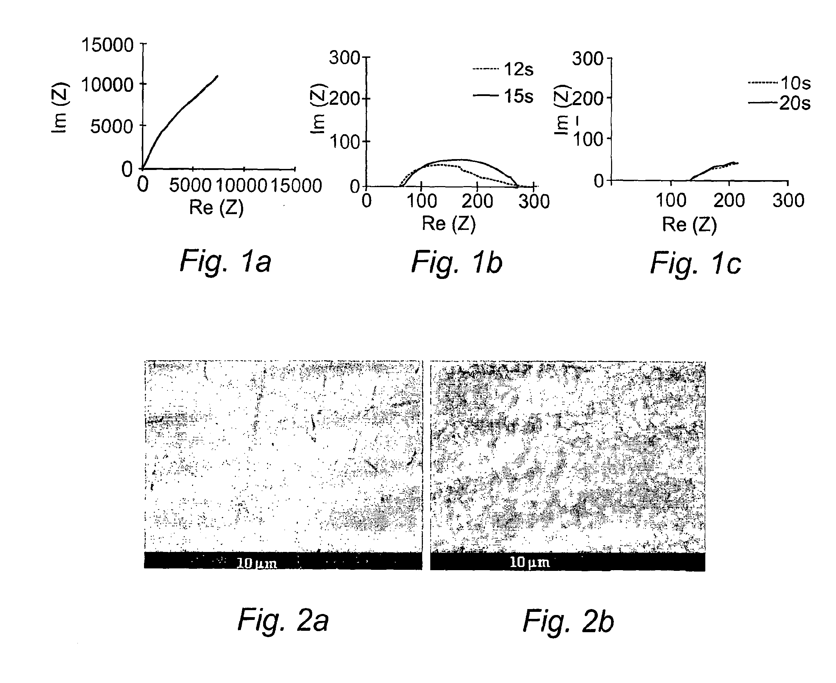

As a standard, the non-treated electrode samples were first characterised by electrochemistry and SEM. The silver thin-films (Ag TF) deposited by evaporation technique have a very smooth surface and react poorly with the electrolyte (large impedance), as shown in Figure 1(a).

After electrochemical chloriding of the electrode samples, SEM analysis shows large granules at the surface of the silver layer, giving a very rough surface topography. Islands of silver chloride have grown, generating a non-uniform surface as shown in Fig 2(a) at which the electrolyte can react easily. Once the Ag/AgCl reduction/oxidation couple is formed, a nearly non-polarisable electrode is obtained. The presence of AgCl layer which acts as a bridge between the electrode and the electrolyte and the roughening of the electrode surface are directly linked to the overall electrode impedance. As shown in Fig 1(b) a reduced impedence of a factor of 100 is realised for the sample electrodes treated in this manner (electrochemical electrode). The impedence of the electrochemical electrode was tested at intervals of 12 and 15 seconds and show that the impedence of this electrode increases with time which is an indication that the AgCl layer is not stable.

For the electrode samples treated according to the present invention (plasma electrodes) with a chlorine plasma stream, a similar reduction in impedence is also observed. This treatment apparently created a singular physical reaction between the silver layer and the chlorine atoms, molecules and ions present within the plasma. The impedance is also lower than that of the sample electrodes by a factor of 100 as shown in Fig 1(c), and this can be achieved only if a "bridge" behaving compound, able of exchanging charges with the electrolyte, is created.

SEM analysis of the plasma electrode show pictures of a "cauliflower" like structure similar to that of the electrochemical electrode. However, in the case of a plasma electrode the layer formed thereon is thinner, more uniform and more controllable. The layer so-formed includes what appears to be a combination of an AgCl film, a chloride form of chlorine (Cl) and individual chlorine atoms which are embedded in the surface of the silver.

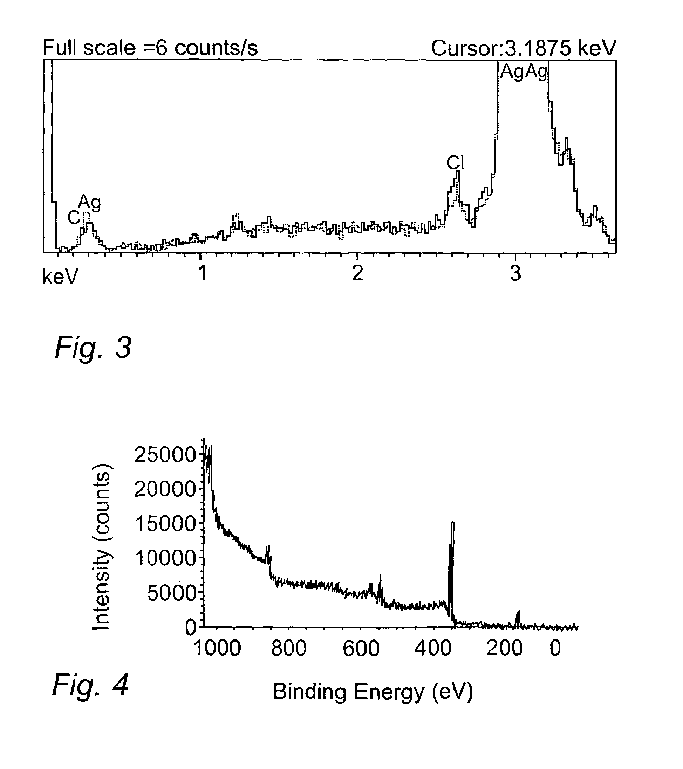

The similarity in behaviour and structure obtained after the two treatments (1) and (2) above possibly suggest that a similar AgCl film was created in each case. However, EDX measurements of the plasma electrode, shown in Fig. 3, show the presence of remaining chlorine atoms in the surface of the silver electrode, which supports the feasibility of creating an AgCl film using this treatment.

XPS measurements were carried out on several sample electrodes treated with plasma streams other than chlorine plasma in order to determine the chemical nature and physical structure of the AgCl thin film formed from the second treatment process. The plasmas used were from similar reactive gases such as fluorine (Fl) as AgCl can be approximated to behave as any other form of silver halide; their electronic structure being very similar. The XPS results show energy peaks related to the Ag 3d and the Cl 2p electronic orbits as shown in Fig 4.

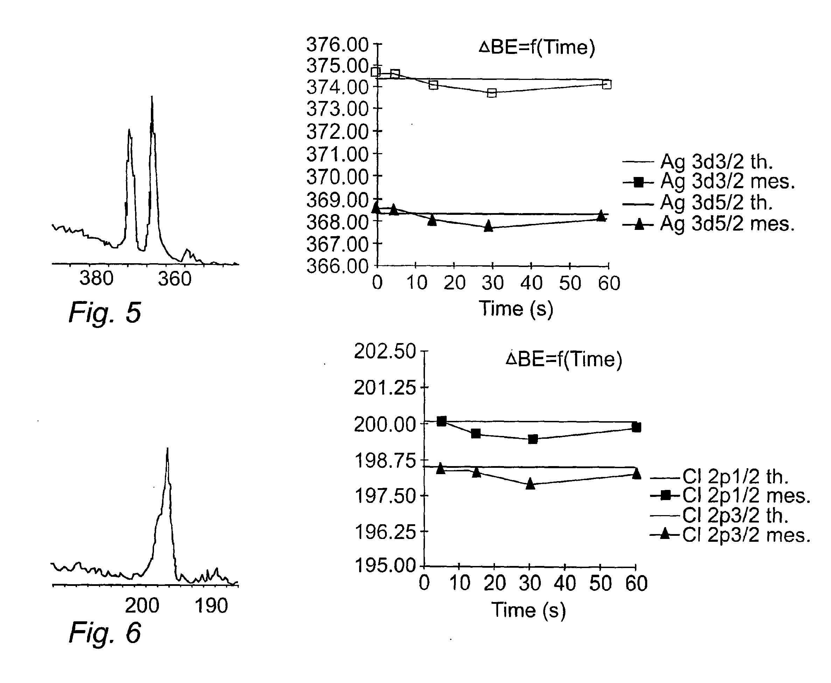

The shifts in energy are related to changes within these electronic orbits. First of all, as shown by EDX measurements chlorine peaks on spectra show that the surface modification compound remains at the surface of the electrode sample after plasma treatment. Then, both chlorine and silver peaks are shifted towards lower energies. Fig 5 and 6 compare the value of these peaks to pure silver and chlorine theoretical peaks, as referred in literature [*ref. Web + XPS Handbook*]. Silver halides (AgI and AgF) Ag 3d_{5/2} peaks show a ± 0.27eV shift compared to pure silver. The silver peak of the plasma treated sample electrode is shifted by about ± 0.4 for the same Ag 3d_{5/2} peak. The energy shift spread is similar to the other silver halides tested. AgCl can be expected to behave in a similar manner to other forms of silver halide as the electronic structure of each are very similar. Nevertheless, the exact values can not be deducted using the energy peak values of the other silver halides, but does provide a close enough idea of the expected energy shift range. Furthermore, quantification of the different elements existing at the surface of the silver thin-film, showed that silver and chlorine are the main species (respectively 75% to 80% and 12% to 17%), and only very few contaminants are present (i.e. carbon and oxygen). Thus, only few oxide forms of silver must be created, leaving the shift in the peaks under the influence of the chlorine ions.

Chlorine was also detected in a chloride form, as the Cl 2p_{3/2} peaks are within the same region of binding energy as the alkali chloride, as shown in Fig 5, with an energy shift of about -0.25eV. Even if this chloride shift is compared to a non-metal chloride form, one can still assume that the structure of AgCl and NaCl are close enough to give a very similar electronic distribution of the molecular orbits (M.O.), and hence an analogous shift value.

### DISCUSSION

These results support the idea that the chlorine ions within the plasma, react chemically with the silver surface and create a halide silver/alkali chloride structure type.

The texture and macro-appearance of the plasma electrodes are not similar to the electrochemical electrodes and this is clearly shown by comparison of Fig 2(a) and Fig 2(b). The plasma electrodes gave a matt yellowish colour, as described for abnormally electrochlorided electrodes in Crenner et al. When increasing the chloriding time for a given input power and chlorine flux, the colour of the sample electrodes turn from a white/yellowish shade to a.brown/plum tint- It has been reported (Yalcinkaya and Power (1997), Janz and Ives (1968)and Beck and Rice (1984)) that the latter tint is characteristic of a further reduction of AgCl to free interstitial Ag, and that "the white allotropic form of AgCl does not correspond to the standard state for crystalline silver chloride". Actually, Neuman Michael (1995) 2^{nd} edition reported that "pure silver chloride is amber coloured and becomes dark grey because of fine particles of silver". These rough optical observations are consistent with the fact that none or poor crystalline AgCl would be expected to grow at the surface of the thin film, producing a matt yellowish colour. Further exposure to the chlorine plasma, which is highly reactive, could be susceptible to induce silver sputtering or etching (as it can be observed on the SEM pictures). Therefore, it is possible that an increasing number of silver particles could be trapped within the created silver chloride, leading to a darker colour specific to the interstitial silver.

The present invention provides a method for providing silver modification by chlorine, to produce thin-film silver electrodes with a very controlled surface. Such electrodes can provide quantitative quality of measurement.

## Claims

1. A method to reduce the impedance of a silver electrode surface wherein the surface is treated with a chlorine plasma.

2. A method as claimed in Claim 1 wherein the silver electrode is in the form of a silver thin-film.

3. A method as claimed in Claim 2 wherein the electrode is fabricated by an evaporation of silver onto a glass plate.

4. A method as claimed in Claim 3 wherein the glass plate is coated with a thin metallic sub-layer prior to the addition of silver.

5. A method as claimed in Claim 4 wherein the sub-layer is a chromium or nichrome.

6. A method as claimed in Claim 5 wherein the sub-layer is coated on the glass plate using a sputtering system.

7. A method as claimed in any one of the preceding Claims wherein the method is carried out in a plasma chamber.

8. A method as claimed in Claim 7 wherein the plasma chamber is a reaction ion etching radio-frequency plasma chamber.

9. A method as claimed in Claim 7 or Claim 8 wherein the plasma chamber is pumped down prior to modification of the silver electrode or metal surface.

10. A method as claimed in Claim 9 wherein the operating pressure in the plasma chamber is within the range 1 to 100mTorr.

11. A method as claimed in any one of the preceding claims wherein the operating power is in the range of 5 to 500 Watts (per cm²).

12. A method as claimed in any one of the preceding Claims wherein the operating flux density method is within the range 1 to 50 sccms of gas.

13. A method as claimed in Claim 12 wherein the gas is chlorine.

14. A method as claimed in any one of the preceding Claims wherein the operating time is within the range 1ms to 5 seconds plasma time.

15. A silver electrode having a silver chloride surface layer provided by plasma modification.

## Patentansprüche

1. Ein Verfahren zum Reduzieren der Impedanz einer Oberfläche einer Silberelektrode, wobei die Oberfläche mit einem Chlorplasma behandelt wird.

2. Verfahren gemäß Anspruch 1, wobei die Silberelektrode in der Form einer Dünnschicht aus Silber vorliegt.

3. Verfahren gemäß Anspruch 2, wobei die Elektrode durch eine Verdampfung von Silber auf eine Glasscheibe gefertigt wird.

4. Verfahren gemäß Anspruch 3, wobei die Glasscheibe vor der Zugabe von Silber mit einer dünnen metallischen Unterschicht beschichtet wird.

5. Verfahren gemäß Anspruch 4, wobei die Unterschicht ein Chrom oder Nichrom ist.

6. Verfahren gemäß Anspruch 5, wobei die Unterschicht unter Verwendung eines Sputtersystems auf die Glasscheibe aufgetragen ist.

7. Verfahren gemäß einem der vorhergehenden Ansprüche, wobei das Verfahren in einer Plasmakammer ausgeführt wird.

8. Verfahren gemäß Anspruch 7, wobei die Plasmakammer eine Reaktives Ionenätzen Radiofrequenz-Plasmakammer ist.

9. Verfahren gemäß Anspruch 7 oder Anspruch 8, wobei die Plasmakammer vor der Modifizierung der Silberelektrode oder Metalloberfläche abgepumpt wird.

10. Verfahren gemäß Anspruch 9, wobei sich der Betriebsdruck in der Plasmakammer innerhalb des Bereichs von 1 bis 100 mTorr befindet.

11. Verfahren gemäß einem der vorhergehenden Ansprüche, wobei sich der Betriebsdruck im Bereich von 5 bis 500 Watt (pro cm²) befindet.

12. Verfahren gemäß einem der vorhergehenden Ansprüche, wobei sich das Betriebsflussdichteverfahren im Bereich von 1 bis 50 sccms Gas befindet.

13. Verfahren gemäß Anspruch 12, wobei das Gas Chlor ist.

14. Verfahren gemäß einem der vorhergehenden Ansprüche, wobei sich die Betriebszeit im Bereich von 1 ms bis 5 Sekunden Plasmazeit befindet.

15. Eine Silberelektrode mit einer Oberflächenschicht aus Silberchlorid, die durch Plasmamodifizierung bereitgestellt wird.

## Revendications

1. Un procédé pour réduire l'impédance d'une surface d'électrode en argent dans lequel la surface est traitée avec un plasma de chlore.

2. Un procédé tel que revendiqué dans la revendication 1 dans lequel l'électrode en argent est sous la forme d'un film mince d'argent.

3. Un procédé tel que revendiqué dans la revendication 2 dans lequel l'électrode est fabriquée par une évaporation d'argent sur une plaque de verre.

4. Un procédé tel que revendiqué dans la revendication 3 dans lequel la plaque de verre est revêtue d'une sous-couche métallique mince préalablement à l'ajout d'argent.

5. Un procédé tel que revendiqué dans la revendication 4 dans lequel la sous-couche est un chrome ou nichrome.

6. Un procédé tel que revendiqué dans la revendication 5 dans lequel la sous-couche est étalée sur la plaque de verre en utilisant un système de pulvérisation.

7. Un procédé tel que revendiqué dans n'importe laquelle des revendications précédentes dans lequel le procédé est effectué dans une chambre à plasma.

8. Un procédé tel que revendiqué dans la revendication 7 dans lequel la chambre à plasma est une chambre à plasma radiofréquence pour gravure ionique réactive.

9. Un procédé tel que revendiqué dans la revendication 7 ou la revendication 8 dans lequel la chambre à plasma est évacuée par pompage préalablement à une modification de l'électrode en argent ou de la surface de métal.

10. Un procédé tel que revendiqué dans la revendication 9 dans lequel la pression de fonctionnement dans la chambre à plasma se trouve au sein de la gamme allant de 1 à 100 mTorrs.

11. Un procédé tel que revendiqué dans n'importe laquelle des revendications précédentes dans lequel la puissance de fonctionnement se trouve dans la gamme allant de 5 à 500 watts (par cm²).

12. Un procédé tel que revendiqué dans n'importe laquelle des revendications précédentes dans lequel le procédé de densité de flux de fonctionnement se trouve au sein de la gamme allant de 1 à 50 sccms de gaz.

13. Un procédé tel que revendiqué dans la revendication 12 dans lequel le gaz est du chlore.

14. Un procédé tel que revendiqué dans n'importe laquelle des revendications précédentes dans lequel le temps de fonctionnement se trouve au sein de la gamme allant de 1 ms à 5 secondes temps plasma.

15. Une électrode en argent ayant une couche de surface de chlorure d'argent fournie par modification de plasma.
